# EUROPEAN PATENT SPECIFICATION

(11) **EP 0 493 854 B1**
(45) Date of publication and mention of the grant of the patent: **09.10.1996**
(21) Application number: 91203337.0
(22) Date of filing: 18.12.1991
(51) Int. Cl.: H01L 27/082, H01L 21/82

(54) **Integrated structure of a bipolar power transistor and a low voltage bipolar transistor in the emitter switching or semibridge configurations and associated manufacturing processes**
Integrierte Struktur eines bipolaren Leistungstransistors und eines Wiederspannungsbipolartransistors in Emittorschaltungs- oder Halbbrückenanordnung und dies bezügliche Herstellungsverfahren
Structure intégrée d'un transistor de puissance et d'un transistor à basse-tension dans une configuration à commutation d'émetteur ou semi-pont et procédés de fabrication associés

(30) Priority: 31.12.1990 IT 2257790
(43) Date of publication of application: 08.07.1992
(73) Proprietor: SGS-THOMSON MICROELECTRONICS S.r.l., I-20041 Agrate Brianza (Milano) (IT); CONSORZIO PER LA RICERCA SULLA MICROELETTRONICA NEL MEZZOGIORNO, I-95121 Catania (IT)
(72) Inventor: Puzzolo, Santo, I-95127 Catania (IT); Zambrano, Raffaele, I-95037 San Giovanni La Punta (IT); Paparo, Mario, I-95037 San Giovanni La Punta (IT)
(74) Representative: Arena, Giovanni

(56) References cited:
- EP-A- 0 322 040
- EP-A- 0 322 041
- EP-A- 0 347 550

## Description

The object of the present invention is an integrated structure of a bipolar power transistor and a low voltage bipolar transistor in the emitter switching or semibridge configurations and associated manufacturing processes.

Emitter switching is a circuit configuration in which a low voltage transistor of the MOS or bipolar type interrupts the emitter current of a high voltage power transistor, typically a bipolar transistor.

With low voltage transistors of the bipolar type this configuration was heretofore provided with discrete components while with low voltage transistors of the MOS type it was also provided with components integrated in the same chip of semiconductor material. An example of an integrated structure in the emitter switching configuration with low voltage transistor of the MOS type is illustrated in EP-A-322041.

An example of vertical bipolar transistors of different conductivity type realized one at the side of the other in a same semiconductor substrate is described in EP-A-347550.

In addition to the advantages which an integrated circuit generally has compared with an analog circuit provided with discrete components, an integrated form of an emitter switching circuit configuration also allows:
- increased ruggendness of the bipolar power transistor as concerns the possibility of occurrence of reverse secondary breakdown phenomena (Es/B);
- joining to the voltage and current capabilities of the driven transistor the performance of speed of the low voltage transistor;
- direct driving of the system with linear logic circuits through the base of the low voltage transistor.
The integrated structure of a bipolar power transistor and a low voltage bipolar transistor in the emitter switching or semibridge configurations in accordance with the present invention thus allows the above advantages. In addition, as compared with the integrated structure with low voltage transistor of the MOS type described in the above-mentioned EP-A-322041, it has the further advantage of being made by means of simpler and more economical manufacturing processes.

The structure and processes which in accordance with the present invention allow the aforesaid advantages are set forth in the claims below.

The invention will be further clarified by the description given below and the annexed drawings of nonlimiting examDles of embodiments of the invention, in which:
- FIG.1: shows schematically the eauivalent electrical circuit of the integrated circuit in accordance with the present invention in the 5-terminal version,
- FIGS. 2-7: show schematically a structure in accordance with the present invention during the various steDs of the manufacturing process,
- FIG.8: shows schematically the structure at the end of the process indicated in the above FIGS. 2-7,
- FIG.8A: shows schematically the structure at the end of the process indicated in the above FIGS. 2-7 with the addition of the sinker region and the overlying contact Cp,
- FIG.9: shows schematically the profile of the concentrations of the various types of dopant along a section of the structure of FIG. 7.

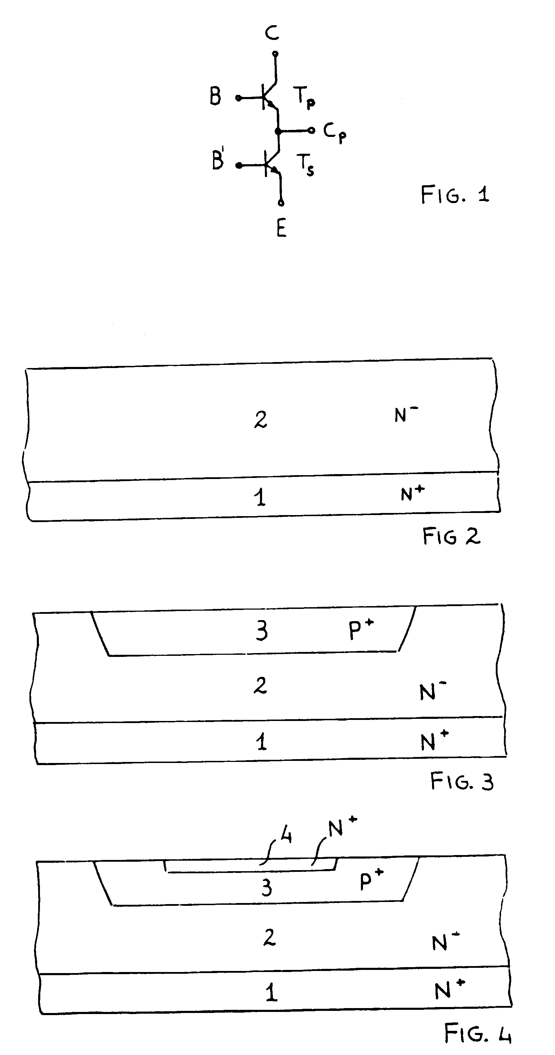

FIG. 1 shows the electrical circuit equivalent of the integrated structure which the present invention intends to provide in the 5-terminal version.

Said circuit consists of a bipolar power transistor Tp connected through its own emitter to the collector of a low voltage bipolar transistor Ts. The electrode Cp for connection of the buried collector of the low voltage transistor Ts and the emitter of Tp is unnecessary for the emitter switching configuration while it is essential for operation of the circuit in semibridge configuration. In this latter case a current flows in the node Cp in one direction or the opposite direction depending on the conduction state of the transistorS Tp and Ts. which, in order to avoid shorting to ground. cannot be in conduction at the same time.

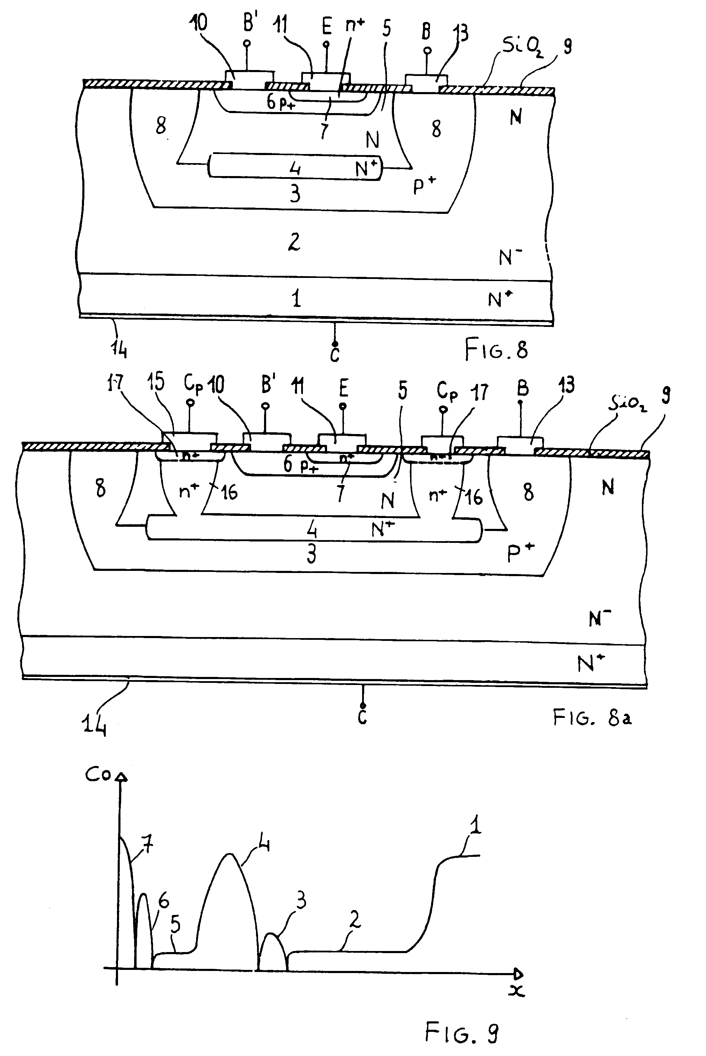

The manufacturing process for the integrated structure in a version with superimposed components not isolated from each other as shown in FIG. 8, is hereinafter described.

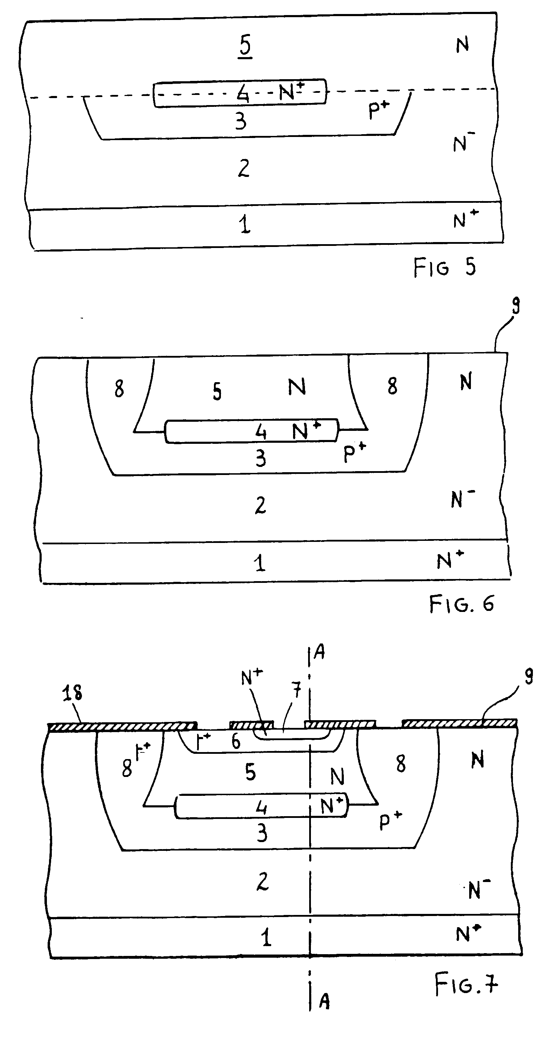

On a silicon substrate 1 of type n+ (FIG.2) there is grown a first epitaxial layer 2 with n- conductivity and high resistivity. On said layer 2 is then obtained by an ion implantation and subsequent diffusion process a type p+ region 3 (FIG.3). By a similar process there is then provided an n+ region 4 (FIG.4). There follows growth of a second epitaxial layer 5 of type n (FIG.5) and, by known oxidation, photomasking, implantation and diffusion processes, definition of the p+ regions 8 which extend from the surface 9 of the chip until they reach the region 3 (as illustrated in FIG.6) so as to enclose therein the collector region (5) of Ts.

FIG.7 represents the structure after a subsequent step. i.e. after the growth (again using known techniques) on the surface layer 18 of thermal oxide SiO₂, and the defining of p+ region 6 and n+ region 7 which make up the base and emitter respectively of the npn transistor indicated by Ts in the equivalent circuit of FIG. 1. In said FIG. 7 the emitter of the transistor Tp consists of the n+ region 4 completely buried. The collector of the low voltage transistor is thereby connected directly to the emitter 4 of the power transistor.

There follow the metallizations 10, 11, 13 and 14 designed to ensure ohmic contact with the regions 6, 7, 8 and the substrate 1 and to constitute the terminals B', E, B and C, which have the same meaning as the homologous terminals of FIG. 1.

The final structure resulting from the process described above is shown in FIG. 8.

If said structure of FIG. 8 is to be used in the semibridge configuration it must be integrated with the regions which allow access through an added terminal Cp to the buried emitter region 4 of the power transistor.

For this purpose the manufacturing process described above must be changed as follows. After the steps which lead to the structure of FIG. 6 known photomasking, implantation and diffusion processes are used to provide the n+ sinker regions (the regions 16 of FIG. 8a) which extend from the surface of the chip until they reach the buried region 4. The definition of the p+ region 6 and of the n+ regions indicated by reference numbers 7 and 17 in FIG. 8a, is then carried out, the regions 17 being sinker enriched regions aimed at improving the contacts and reducing the electrical resistance of the sinker. After the last steps of metallization and provision of the electrodes, the structure appears as shown in FIG. 8a.

The profile of the concentration (Co) of the various types of dopant in the different regions of the structure, along plane of cut A-A of FIG. 7, is illustrated in FIG. 9 where on the axis X is shown the distance from the upper surface of the chip.

It is noted that the terminal Cp can be necessary also in the emitter switching configuration in order to detect the voltage present on the collector of Ts, prevent full saturation of Ts through control of its base current (anti saturation circuit) and thus speed up its switching.

The first epitaxial growth on the substrate could be unnecessary if a substrate with characteristics equivalent to those of the substrate mentioned above (substrate 1 of FIG. 2) is adopted after growth of the first epitaxial layer.

In addition, although the present invention is illustrated for a structure with npn transistors, it also applies, with variations apparent to those skilled in the art, to structures with pnp transistor provided, in this case, starting from a type p substrate.

The processes described lend themselves naturally to simultaneous embodiment on the same chip of several pairs of bipolar transistors Tp and Ts. This finds application, for examDle, in semibridge structures for control of direct current or step motors (for which two pairs are sufficient) and for control of 3-phase current motors (for which three pairs are needed).

In these cases all the transistors Tp are provided on the same substrate and therefore have a common collector terminal while the electrodes of each pair provided on the front of the chip can be connected together and to the external circuitry depending on design requirements.

## Claims

1. Structure comprising a bipolar power transistor, hereinafter called Tp, and a low voltage bipolar transistor, hereinafter called Ts, in the emitter switching configuration integrated in a same chip of semiconductor material, characterized by the presence in combination of:
- a semiconductor substrate (1,2) with a first type of conductivity constituting the collector of Tp,
- a first region (3) with a second type of conductivity opposite said first type of conductivity, provided in the substrate (1,2) and constituting the base region of Tp,
- a second region (4) with the first type of conductivity provided in said first region (3), constituting the emitter of Tp and at the same time the collector of Ts,
- an epitaxial layer (5) with the first type of conductivity disposed on the entire surface of the chip,
- third regions (8) with the second type of conductivity, formed in said epitaxial layer (5) and connected to said first region (3) so as to enclose therein a fourth region, constituting the collector region (5) of Ts,
- a fifth region (6) with the second type of conductivity constituting the base of Ts, defined in a portion of said fourth region (5),
- a sixth region (7) with the first type of conductivity, provided in said fifth region (6) and constituting the emitter region of Ts,
- metallizations on the front of the chip constituting the emitter electrodes (E) of Ts, base electrodes (B') of Ts, and base electrodes (B) of Tp,
- a metallization on the entire back surface of the chip constituting the collector electrode (C) of Tp.

2. Structure in accordance with claim 1 characterized in that the substrate (1,2) comprises a further epitaxial layer (2) in which is provided said first region (3).

3. Structure comprising a bipolar power transistor thereinafter called Tp, and a low voltage bipolar transistor, hereinafter called Ts, in the semibridge configuration integrated in a same chip of semiconductor material, characterized by the presence in combination of:
- a semiconductor substrate (1/2) with a first type of conductivity constituting the collector of Tp,
- a first region (3) with a second type of conductivity opposite said first type of conductivity, provided in the substrate (1,2) and constituting the base region of Tp,
- a second region (4) with the first type of conductivity provided in said first region (3), constituting the emitter of Tp and at the same time the collector of Ts,
- an epitaxial layer (5) with the first type of conductivity disposed on the entire surface of the chip,
- third regions (8) with the second type of conductivity, formed in said epitaxial layer (5) and connected to said first region (3) so as to enclose therein a fourth region, constituting the collector region (5) of Ts,
- a fifth region (6) with the second type of conductivity constituting the base of Ts, defined in a portion of said fourth region (5),
- a sixth region (7) with the first type of conductivity, provided in said fifth region (6) and constituting the emitter region of Ts,
- metallizations on the front of the chip constituting the emitter electrodes (E) of Ts, base electrodes (B') of Ts, and base electrodes (B) of Tp,
- a metallization on the entire back surface of the chip constituting the collector electrode (C) of Tp.
- at least one sinker region (16,17) with the first conductivity type formed in said fourth region (5) designed to carry said second region to the surface of the chip,
- at least one metallization (15) on the front of the chip constituting an electrode (Cp) for connection to said sinker region (16,17).

4. Structure in accordance with claim 3 characterized in that the substrate (1,2) comprises a further epitaxial layer (2) in which is provided said first region (3).

5. Structure in accordance with claim 3 characterized in that said sinker region (16,17) connects to the entire contour of said second region (4) so as to completely enclose said fifth region (6).

6. Structure in accordance with claim 5 characterized in that said sinker region (16,17) has a higher percentage of dopant in a part (17) near the surface of the chip.

7. Process for manufacturing a circuit structure integrated in a chip of semiconductor material, comprising a bipolar power transistor and a low voltage bipolar transistor in the emitter switching configuration, which comprises:
- creating, in a silicon substrate (1,2) of a first type of conductivity, a first region (3), having a second type of conductivity which is opposite said first type of conductivity, by deposition or ion implantation of dopant and subsequent diffusion process,
- providing a second region (4) having the first type of conductivity, inside said first region (3), by deposition or ion implantation of dopant and subsequent diffusion process
- growing an epitaxial layer (5) of the first type of conductivity,
- defining third regions (8), of the second type of conductivity, inside said epitaxial layer (5), by known oxidation, photomasking, deposition or implantation of dopant and diffusion processes, said third regions extending from the surface (9) of the chip to said first region (3), so as to define and enclose therein a fourth region (5) of the first type of conductivity,
- growing a layer (18) of thermal oxide SiO₂ on the surface of said epitaxial layer (5),
- defining a fifth region (6) of the second type of conductivity, inside said fourth region (5),
- defining a sixth region (7) of the first type of conductivity, inside said fifth region (6),
- realizing ohmic contacts with said third, fifth, sixth regions and with the back of the substrate by metallization.

8. Process for manufacturing a circuit structure in accordance with claim 7 characterized in that, before creating said first region (3) another epitaxial layer (2) of the first type of conductivity is grown on said substrate (1,2).

9. Process for manufacturing a circuit structure integrated in a chip of semiconductor material, comprising a bipolar power transistor and a low voltage bipolar transistor in the semibridge configuration, which comprises:
- creating, in a silicon substrate (1,2) of a first type of conductivity, a first region (3), having a second type of conductivity which is opposite said first type of conductivity, by deposition or ion implantation of dopant and subsequent diffusion process,
- providing a second region (4) having the first type of conductivity, inside said first region (3), by deposition or ion implantation of dopant and subsequent diffusion process
- growing an epitaxial layer (5) of the first type of conductivity,
- defining third regions (8), of the second type of conductivity, inside said epitaxial layer (5), by known oxidation, photomasking, deposition or implantation of dopant and diffusion processes, said third regions ex-tending from the surface (9) of the chip to said first region (3), so as to define and enclose therein a fourth region (5) of the first type of conductivity,
- realizing seventh regions (16) of the first type of conductivity inside said fourth region (5), extending from the surface (9) of the chip to said second region (4),
- growing a layer (18) of thermal oxide SiO₂ on the surface of said epitaxial layer (5),
- defining a fifth region (6) of the second type of conductivity, inside said fourth region (5),
- defining a sixth region (7) of the first type of conductivity, inside said fifth region (6),
- realizing ohmic contacts with said third, fifth, sixth, and seventh regions and with the back of the substrate by metallization.

10. Process for manufacturing a circuit structure in accordance with claim 9 characterized in that, before creating said first region (3) another epitaxial layer (2) of the first type of conductivity is grown on said substrate (1,2).

## Patentansprüche

1. Struktur mit einem bipolaren Leistungstransistor, nachfolgend mit Tp bezeichnet, und einem bipolaren Niederspannungstransistor, nachfolgend mit Ts bezeichnet, in Emitterschaltkonfiguration in integrierter Schaltung auf dem selben Halbleitermaterialplättchen, gekennzeichnet durch das Vorhandensein der folgenden Kombination:
- ein Halbleitersubstrat (1, 2) eines ersten Leitungstyps, welcher den Kollektor von Tp bildet,
- eine in dem Substrat (1, 2) ausgebildete und die Basiszone von Tp bildende erste Zone (3) eines zweiten Leitungstyps, welche dem ersten Leitungstyp entgegengesetzt ist,
- eine in der ersten Zone (3) vorgesehene zweite Zone (4) des ersten Leitungstyps, welche den Emitter von Tp und gleichzeitig den Kollektor von Ts bildet,
- eine epitaktische Schicht (5) vom ersten Leitungstyp, die auf der gesamten Plättchenoberfläche angeordnet ist,
- in der epitaktischen Schicht (5) gebildete dritte Zonen (8) vom zweiten Leitungstyp, die mit der ersten Zone (3) verbunden sind und eine die Kollektorzone (5) von Ts bildende vierte Zone einschließen,
- eine in einem Teil der vierten Zone (5) begrenzte fünfte Zone (6) vom zweiten Leitungstyp, welche die Basis von Ts bildet,
- eine in der fünften Zone (6) vorgesehene sechste Zone (7) vom ersten Leitungstyp, welche die Emitterzone von Ts bildet,
- auf der Front des Plättchens befindliche Metallisierungen, welche die Emitterelektroden (E) von Ts, die Basiselektroden (B') von Ts und die Basiselektroden (B) von Tp bilden,
- eine auf der gesamten Rückfläche des Plättchens vorgesehene Metallisierung, welche die Kollektorelektrode (C) von Tp bildet.

2. Struktur nach Anspruch 1, bei welcher der Substrat (1, 2) eine weitere epitaktische Schicht (2) umfaßt, in welcher die erste Zone (3) vorgesehen ist.

3. Struktur mit einem bipolaren Leistungstransistor, nachfolgend mit Tp bezeichnet, und einem bipolaren Niederspannungstransistor, nachfolgend mit Ts bezeichnet, in Halbbrückenkonfiguration, integretiert in dem selben Halbleitermaterialplättchen, dadurch gekennzeichnet, daß in Kombination vorhanden sind:
- ein Halbleitersubstrat (1, 2) eines ersten Leitungstyps, welcher den Kollektor von Tp bildet,
- eine im Substrat (1, 2) vorgesehene, die Basiszone von Tp bildende erste Zone (3) eines zweiten Leitungstyps, welcher dem ersten Leitungstyp entgegengesetzt ist,
- eine in der ersten Zone (3) vorgesehene zweite Zone (4) vom ersten Leitungstyp, welche den Emitter von Tp und gleichzeitig den Kollektor von Ts bildet,
- eine epitaktische Schicht (5) vom ersten Leitungstyp, die auf der gesamten Oberfläche des Plättchens angeordnet ist,
- in der epitaktischen Schicht (5) ausgebildete dritte Zonen (8) vom zweiten Leitungstyp, welche mit der ersten Zone (3) verbunden sind und eine die Kollektorzone (5) von Ts bildende vierte Zone einschließen,
- eine in einem Teil der vierten Zone (5) definierte fünfte Zone (6) vom zweiten Leitungstyp, welche die Basis von Ts darstellt,
- eine in der fünften Zone (6) vorgesehene sechste Zone (7) vom ersten Leitungstyp, welche die Emitterzone von Ts bildet,
- auf der Front des Plättchens vorgesehne Metallisierungen, welche die Emitterelektroden (E) von Ts, die Basiselektroden (B') von Ts und die Basiselektroden (B) von Tp bilden,
- eine auf der gesamten Rückfläche des Plättchens vorgesehene Metallisierung, welche die Kollektorelektrode (C) von Tp bildet,
- mindestens eine in der vierten Zone (5) ausgebildete Einsenkzone (16, 17) vom ersten Leitungstyp, welche derart bemessen ist, daß sie die zweite Zone an die Oberfläche des Plättchens heranführt,
- mindestens eine Metallisierung auf der Front des Plättchens, welche eine Elektrode (Cp) zur Verbindung mit der Einsenkzone (16, 17) bildet.

4. Struktur nach Anspruch 3, dadurch gekennzeichnet, daß das Substrat (1, 2) eine weitere epitaxiale Schicht (2) umfaßt, in welcher die erste Zone (3) vorgesehen ist.

5. Struktur nach Anspruch 3, dadurch gekennzeichnet, daß die Einsenkzone (16, 17) mit der gesamten Kontur der zweiten Zone (4) in Verbindung steht und die fünfte Zone (6) vollständig einschließt.

6. Struktur nach Anspruch 5, dadurch gekennzeichnet, daß die Einsenkzone (16, 17) in einem Teil (17) nahe der Plättchenoberfläche einen höheren Prozentsatz von Dotierstoff enthält.

7. Verfahren zur Herstellung einer Schaltungsstruktur in integrierter Form in einem Plättchen aus Halbleitermaterial, welches einen bipolaren Leistungstransistor und einen bipolaren Niederspannungstransistor in Emitterschaltungskonfiguration enthält, umfassend:
- Ausbildung einer ersten Zone (3) eines zweiten Leitungstyps in einem Siliziumsubstrat (1, 2) eines ersten Leitungstyps, wobei der zweite Leitungstyp dem ersten entgegengesetzt ist, durch Ablagerung oder Ionenimplantation von Dotiermittel und nachfolgenden Diffusionsprozeß,
- Vorsehen einer zweiten Zone (4) vom ersten Leitungstyp innerhalb der ersten Zone (3) durch Ablagerung oder Ionenimplantation von Dotiermittel und nachfolgenden Diffusionsprozeß,
- Wachsenlassen einer epitaktischen Schicht (5) vom ersten Leitungstyp,
- Definieren von dritten Zonen (8) des zweiten Leitungstyps innerhalb der epitaktischen Schicht (5) durch bekannte Oxidation, Photomaskierung, Ablagerung oder Implantation von Dotiermittel und Diffusionsverfahren, wobei die dritten Zonen von der Oberfläche (9) des Plättchens zur ersten Zone (3) reichen, um eine vierte Zone (5) des ersten Leitungstyps zu definieren und einzuschließen,
- Wachsenlassen einer Schicht (18) von thermischem Oxid SiO₂ auf der Oberfläche der epitaktischen Schicht (5),
- Definierung einer fünften Zone (6) vom zweiten Leitungstyp innerhalb der vierten Zone (5),
- Definierung einer sechsten Zone (7) vom ersten Leitungstyp innerhalb der fünften Zone (6),
- Ausbildung ohm'scher Kontakte zur dritten, fünften und sechsten Zone sowie zur Rückseite des Substrats durch Metallisierung.

8. Verfahren zur Herstellung einer Schaltungsstruktur nach Anspruch 7, dadurch gekennzeichnet, daß vor der Ausbildung der ersten Zone (3) eine andere epitaktische Schicht (2) vom ersten Leitungstyp auf dem Substrat (1, 2) wachsen gelassen wird.

9. Verfahren zur Herstellung eines Schaltungsaufbaus in integrierter Form auf einem Plättchen aus Halbleitermaterial, enthaltend einen bipolaren Leistungstransistor und einen bipolaren Niederspannungstransistor in Halbbrückenkonfiguration, aufweisend:
- Ausbildung einer ersten Zone (3) eines zweiten Leitungstyps in einem Siliziumsubstrat (1, 2) eines ersten Leitungstyps, wobei der zweite Leitungstyp dem ersten entgegengesetzt ist, durch Ablagern oder Ionenimplantation eines Dotiermittels und nachfolgenden Diffusionsprozeß,
- Vorsehen einer zweiten Zone (4) vom ersten Leitungstyp innerhalb der ersten Zone (3) durch Ablagerung oder Ionenimplantation von Dotiermittel und nachfolgendes Diffusionsverfahren,
- Wachsenlassen einer epitaktischen Schicht (5) vom ersten Leitungstyp,
- Definierung von dritten Zonen (3) des zweiten Leitungstyps innerhalb der epitaktischen Schicht (5) durch Oxidation, Photomaskierung, Ablagerung oder Implantation von Dotiermittel und Diffusionsverfahren, wobei die dritten Zonen sich von der Oberfläche (9) des Plättchens zur ersten Zone (3) erstrecken und eine vierte Zone (5) vom ersten Leitungstyp definieren und einschließen,
- Ausbildung von siebten Zonen (16) des ersten Leitungstyps innerhalb der vierten Zone (5), welche von der Oberfläche (9) des Plättchens zur zweiten Zone (4) reichen,
- Wachsenlassen einer Schicht (18) aus thermischem Oxid Si0₂ auf der Oberfläche der epitaktischen Schicht (5),
- Definierung einer fünften Zone (6) des zweiten Leitungstyps innerhalb der vierten Zone (5),
- Definierung einer sechsten Zone (7) des ersten Leitungstyps innerhalb der fünften Zone (6),
- Ausbildung ohm'scher Kontakte zur dritten, fünften, sechsten und siebten Zone und zur Rückseite des Substrats durch Metallisierung.

10. Verfahren zur Herstellung einer Schaltungsstruktur nach Anspruch 9, dadurch gekennzeichnet, daß vor der Ausbildung der ersten Zone (3) eine andere epitaktische Schicht (2) vom ersten Leitungstyp auf dem Substrat (1, 2) wachsengelassen wird.

## Revendications

1. Structure comprenant un transistor bipolaire de puissance ci-après appelé Tp et un transistor bipolaire basse-tension ci-après appelé Ts en configuration de commutation d'émetteur, intégrés dans une même puce de matériau semiconducteur, caractérisée par la présence en combinaison de :
- un substrat semiconducteur (1, 2) d'un premier type de conductivité constituant le collecteur de Tp,
- une première région (3) d'un second type de conductivité opposé au premier type de conductivité prévue dans le substrat (1, 2) et constituant la région de base de Tp,
- une deuxième région (4) du premier type de conductivité prévue dans la première région (3), constituant l'émetteur de Tp et le collecteur de Ts,
- une couche épitaxiale (5) du premier type de conductivité disposée sur toute la surface de la puce,
- des troisièmes régions (8) du second type de conductivité formées dans la couche épitaxiale (5) et connectées à la première région (3) de façon à y enfermer une quatrième région constituant la région de collecteur (5) de Ts,
- une cinquième région (6) du second type de conductivité constituant la base de Ts, définie dans une partie de la quatrième région (5),
- une sixième région (7) du premier type de conductivité prévue dans la cinquième région (6) et constituant la région d'émetteur de Ts,
- des métallisations sur la face avant de la puce constituant les électrodes d'émetteur (E) de Ts, de base (B') de Ts et de base (B) de Tp,
- une métallisation sur la face arrière de la puce constituant l'électrode de collecteur (C) de Tp.

2. Structure selon la revendication 1, caractérisée en ce que le substrat (1, 2) comprend une autre couche épitaxiale (2) dans laquelle est formée la première région (3).

3. Structure comprenant un transistor bipolaire de puissance ci-après appelé Tp et un transistor bipolaire basse-tension ci-après appelé Ts en configuration de demi-pont, intégrés dans une même puce de matériau semiconducteur, caractérisée par la présence en combinaison de :
- un substrat semiconducteur (1, 2) d'un premier type de conductivité constituant le collecteur de Tp,
- une première région (3) d'un second type de conductivité opposé au premier type de conductivité prévue dans le substrat (1, 2) et constituant la région de base de Tp,
- une deuxième région (4) du premier type de conductivité prévue dans la première région (3), constituant l'émetteur de Tp et le collecteur de Ts,
- une couche épitaxiale (5) du premier type de conductivité disposée sur toute la surface de la puce,
- des troisièmes régions (8) du second type de conductivité formées dans la couche épitaxiale (5) et connectées à la première région (3) de façon à y enfermer une quatrième région constituant la région de collecteur (5) de Ts,
- une cinquième région (6) du second type de conductivité constituant la base de Ts, définie dans une partie de la quatrième région (5),
- une sixième région (7) du premier type de conductivité prévue dans la cinquième région (6) et constituant la région d'émetteur de Ts,
- des métallisations sur la face avant de la puce constituant les électrodes d'émetteur (E) de Ts, de base (B') de Ts et de base (B) de Tp,
- une métallisation sur la face arrière de la puce constituant l'électrode de collecteur (C) de Tp,
- au moins une région de puits (16, 17) du premier type de conductivité formée dans la quatrième région (5) conçue pour prolonger la seconde région vers la surface de la puce,
- au moins une métallisation (15) sur la face avant de la puce constituant une électrode (Cp) de connexion à la région de puits (16, 17).

4. Structure selon la revendication 3, caractérisée en ce que le substrat (1, 2) comprend une autre couche épitaxiale (2) dans laquelle est formée la première région (3).

5. Structure selon la revendication 3, caractérisée en ce que la région de puits (16, 17) relie tout le contour de la deuxième région (4) de façon à entourer complètement la cinquième région (6).

6. Structure selon la revendication 5, dans laquelle la région de puits (16, 17) est plus dopée dans une partie (17) proche de la surface de la puce.

7. Procédé de fabrication d'une structure de circuit intégré dans une puce de matériau semiconducteur comprenant un transistor bipolaire de puissance et un transistor bipolaire basse-tension en configuration de commutation d'émetteur, comprenant les étapes suivantes :
- créer dans un substrat de silicium (1, 2) d'un premier type de conductivité une première région (3) ayant un second type de conductivité qui est opposé au premier type de conductivité par dépôt ou implantation ionique d'un dopant et diffusion ultérieure,
- prévoir une deuxième région (4) ayant le premier type de conductivité à l'intérieur de la première région (3) par dépôt ou implantation ionique d'un dopant et diffusion ultérieure,
- faire croître une couche épitaxiale (5) du premier type de conductivité,
- définir des troisièmes régions (8) du second type de conductivité à l'intérieur de la couche épitaxiale (5) par des procédés connus d'oxydation, de photomasquage, de dépôt ou d'implantation de dopant et de diffusion, les troisièmes régions s'étendant à partir de la surface (9) de la puce vers la première région (3) de façon à définir et enfermer dans celle-ci une quatrième région (5) du premier type de conductivité,
- faire croître une couche (18) d'oxyde thermique SiO₂ sur la surface de la couche épitaxiale (5),
- définir une cinquième région (6) du second type de conductivité à l'intérieur de la quatrième région (5),
- définir une sixième région (7) du premier type de conductivité à l'intérieur de la cinquième région (6),
- réaliser des contacts ohmiques avec les troisième, cinquième et sixième régions et avec la face arrière du substrat par métallisation.

8. Procédé de fabrication d'une structure de circuit selon la revendication 7, caractérisé en ce que, avant de créer la première région (3), une autre couche épitaxiale (2) du premier type de conductivité est amenée à croître sur le substrat (1, 2).

9. Procédé de fabrication d'une structure de circuit intégré dans une puce de matériau semiconducteur comprenant un transistor bipolaire de puissance et un transistor bipolaire basse-tension en configuration de demi-pont, comprenant les étapes suivantes :
- créer dans un substrat de silicium (1, 2) d'un premier type de conductivité une première région (3) ayant un second type de conductivité qui est opposé au premier type de conductivité par dépôt ou implantation ionique d'un dopant et diffusion ultérieure,
- prévoir une deuxième région (4) ayant le premier type de conductivité à l'intérieur de la première région (3) par dépôt ou implantation ionique d'un dopant et diffusion ultérieure,
- faire croître une couche épitaxiale (5) du premier type de conductivité,
- définir des troisièmes régions (8) du second type de conductivité à l'intérieur de la couche épitaxiale (5) par des procédés connus d'oxydation, de photomasquage, de dépôt ou d'implantation de dopant et de diffusion, les troisièmes régions s'étendant à partir de la surface (9) de la puce vers la première région (3) de façon à définir et enfermer dans celle-ci une quatrième région (5) du premier type de conductivité,
- réaliser des septièmes régions (16) du premier type de conductivité à l'intérieur de la quatrième région (5), s'étendant à partir de la surface (9) de la puce vers la deuxième région (4),
- faire croître une couche (18) d'oxyde thermique SiO₂ sur la surface de la couche épitaxiale (5),
- définir une cinquième région (6) du second type de conductivité à l'intérieur de la quatrième région (5),
- définir une sixième région (7) du premier type de conductivité à l'intérieur de la cinquième région (6),
- réaliser des contacts ohmiques avec les troisième, cinquième et sixième régions et avec la face arrière du substrat par métallisation.

10. Procédé de fabrication d'une structure de circuit selon la revendication 9, caractérisé en ce que, avant de créer la première région (3), une autre couche épitaxiale (2) du premier type de conductivité est amenée à croître sur le substrat (1, 2).
